# EUROPEAN PATENT APPLICATION

(11) **EP 2 207 262 A2**
(43) Date of publication of application: **14.07.2010**
(21) Application number: 09175591.8
(22) Date of filing: 10.11.2009
(51) Int. Cl.: H03K 3/356

(54) **Clocked d-type flip flop circuit**

(30) Priority: 09.01.2009 US 319685
(71) Applicant: AU Optronics Corporation, Hsin-Chu 300 (TW)
(72) Inventor: Chen, Chung-Chun, Hsin-Chu (TW); Yang, Kun-Yen, Hsin-Chu (TW); Liao, Wei-Chien, Hsin-Chu (TW)
(74) Representative: Lang, Christian

(57) **Abstract**

A clocked D-type Flip-Flop circuit has a transmission gate to admit an input data and to provide an intermediate output to a clock-controlled inverter based on the clock signals. The clock-controlled inverter is used as a latch for latching the output signal from the transmission gate and releases the latched signal by the same clock signals to an output inverter. The output of the output inverter is the Q terminal of the Flip-Flop circuit. Another output inverter is used to invert the signal from the Q terminal into a complementary output signal. In one of the embodiments of the present invention, another transmission gate is used to condition the complementary output signal.

## Description

### Field of the Invention

The present invention relates to a clocked D-type Flip-Flop circuit.

### Background of the Invention

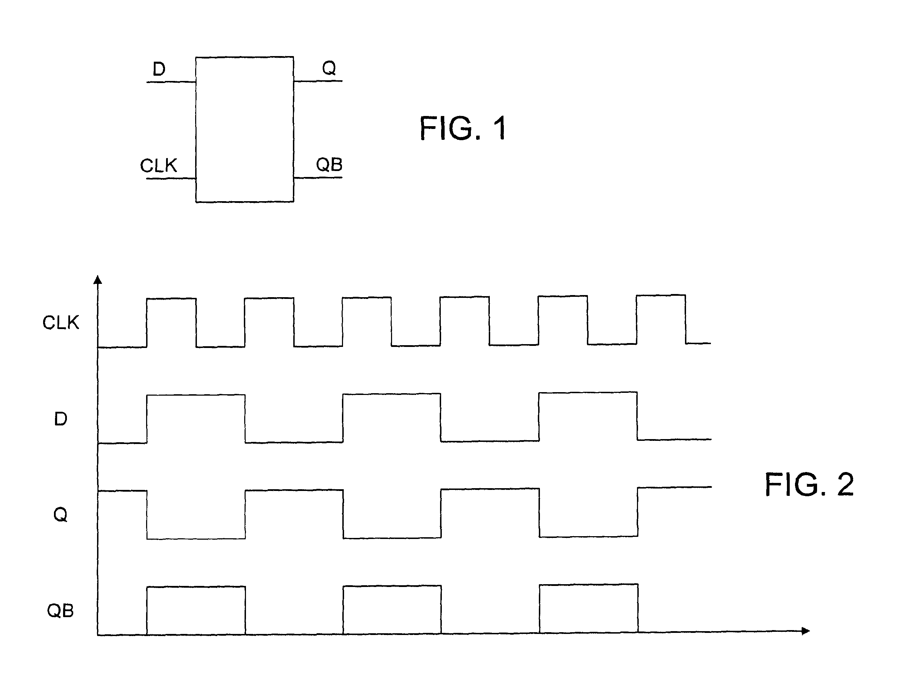

As known in the art, a clocked D-type Flip-Flop receives an input D (data) but the output Q does not response to the transition in the input D unless there is a transition in the state of a clock. Conventionally, the rising edge or the upward transition of the clock enables the transition of the output Q dependent upon whether a transition in D also occurs. Furthermore, the state of the output Q is dependent upon the state of D when the upward transition of the clock occurs. The inputs and outputs of a clocked D-type Flip-Flop chip is shown in Figure 1, and a timing chart showing the relations between the input D, the clock CLK and the output Q is shown in Figure 2.

### Summary of the Invention

The present invention provides a clocked D-type Flip-Flop circuit which has a transmission gate to admit an input data and to provide an intermediate output to a clock-controlled inverter based on the clock signals. The clock-controlled inverter is used as a latch for latching the output signal from the transmission gate and releases the latched signal by the same clock signals to an output inverter. The output of the output inverter is the Q terminal of the Flip-Flop circuit. Another output inverter is used to invert the signal from the Q terminal into a complementary output signal. In one of the embodiments of the present invention, another transmission gate is used to condition the complementary output signal.

The clock-controlled inverter can be a switching series having a first series end and an opposing second series end, the first series end connected to a first voltage source (VDD) and the second series end connected to a second voltage level source (GND) different from the first voltage level source, the switching series comprising a plurality of switching elements (M3-M6) connected in series, wherein the plurality of switching elements comprise:
a first switching element (M3) at the first series end;
a second switching element (M4) electrically connected to the first switching element;
a third switching element (M5) electrically connected to the second switching element; and
a fourth switching element (M6) electrically connected between the third switching element and the second series end, wherein each of the first switching element, the second switching element, the third switching element and the fourth switching element is operable in two complementary switching states, and wherein
the first output signal is arranged to cause the first switching element and the fourth switching element to operate between said two switching states, such that the switching states of the first switching element are complementary to the switching states of the fourth switching element;
the first clock signal is arranged to cause the second switching element to operate between said two switching states; and the second clock signal is arranged to cause the third switching element to operate between said two switching states, such that the switching states of the second switching element are the same as the switching states of the third switching element, and wherein the switching series is configured to provide a second output signal at a first output point (N05) between the second switching and third switching element.

The present invention will become apparent upon reading the description taken in conjunction with Figures 1 to 6.

### Brief Description of the Drawings

Figure 1 shows a clocked D-type Flip-Flop chip.
Figure 2 shows a time chart for a clocked D-type Flip-Flop circuit.
Figure 3 shows a clocked D-type Flip-Flop circuit, according to one embodiment of the present invention.
Figure 4 is a timing chart showing typical signal levels at various nodes of the clocked D-type Flip-Flop circuit, according to various embodiments of the present invention.
Figure 5 shows a clocked D-type Flip-Flop circuit, according to another embodiment of the present invention.
Figure 6 shows a clocked D-type Flip-Flop circuit, according to yet another embodiment of the present invention.

### Detailed Description of the Invention

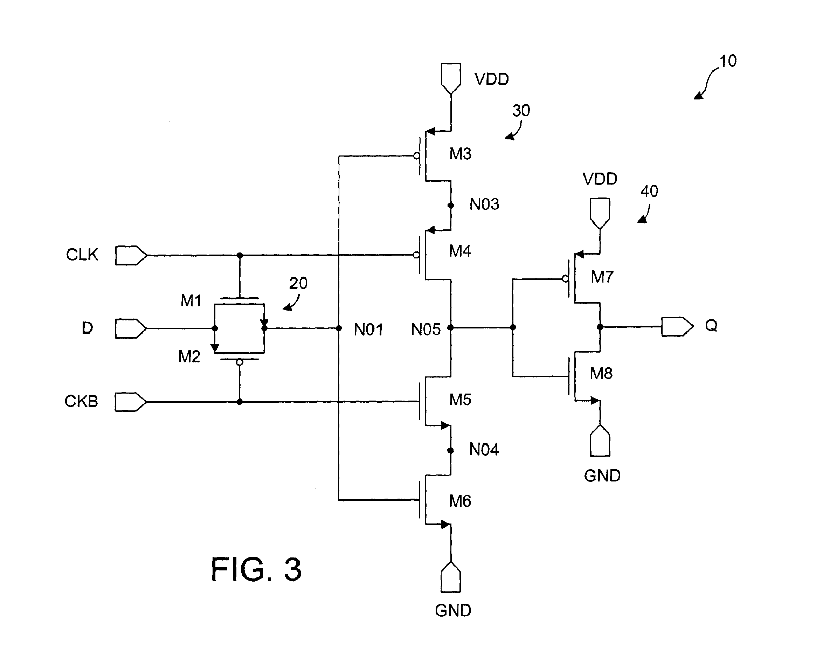

The clocked D-type Flip-Flop circuit, according to various embodiments of the present invention, comprises a transmission gate to admit an input D (data) and to provide an intermediate output to a clock-controlled inverter (or a push-pull section) based on the clock signals. The clock-controlled inverter, in response to the immediate output from the transmission gate and the clock signals, provides an output to an output inverter. As shown in Figure 3, the clocked D-type Flip-Flop circuit **10** comprises a transmission gate **20,** a clock-controlled inverter **30** and an output inverter **40.** All the switching elements in the transmission gate **20,** the clock-controlled inverter **30** and the output inverter **40** are MOS (Metal-Oxide-Semiconductor) FETs (Field Effect Transistors). The transmission gate **20** comprises an n-MOS transistor **M1** and a p-MOS transistor **M2.** The source (S) of the n-MOS transistor **M1** is connected to the drain (D) of the p-MOS transistor **M2.** The drain of the n-MOS transistor **M1** is connected to the source of the p-MOS transistor **M2.** The input **D** is received at the source of the n-MOS transistor **M1**. The gate of the n-MOS transistor **M1** is configured to receive a clock signal **CLK** and the gate of p-MOS transistor **M2** is configured to receive a complementary clock signal **CKB.** The output of the transmission gate **20** is provided at the drain of the n-MOS transistor **M1** to a node **N01**.

According to various embodiments of the present invention, the clock-controlled inverter **30** comprises a plurality of switching elements connected in series. As show in Figure 3, the clock-controlled inverter **30** comprises a first transistor **M3** connected to a first voltage level, such as **VDD,** a second transistor **M4** connected to the first transistor **M3,** a third transistor **M5** connected to the second transistor **M4,** and a fourth transistor **M6** connected between the third transistor **M5** and a second voltage level, such as **GND.** In particular, the first transistor **M3** and the second transistor **M4** are p-MOS transistors, whereas the third transistor **M5** and the fourth transistor **M6** are n-MOS transistors. As shown in Figure 3, the drain of the first transistor **M3** is connected to **VDD,** the drain of the second transistor **M4** is connected to the source of the first transistor **M3,** the source of the third transistor **MS** is connected to the source of the second transistor **M4,** the source of the fourth transistor **M6** is connected to the drain of the third transistor **M5**, and the drain of the fourth transistor **M6** is connected to **GND.** The gate of the first transistor **M3** and the gate of the fourth transistor **M6** are configured to receive the output of the transmission gate **20** at the node **N01**. The gate of the second transistor **M4** is configured to receive the clock signal **CLK** and the gate of the third transistor **M5** is configured to receive the complementary clock signal **CKB.** The output of the clock-controlled inverter **30** is provided to the output inverter **40** from a node **N05**.

The output inverter **40** comprises two switching elements, p-MOS transistor **M7** and n-MOS transistor **M8,** connected in series. As shown in Figure 3, the drain of the p-MOS transistor **M7** is connected to **VDD,** and the drain of the n-MOS transistor **M8** is connected to **GND.** The source of the n-MOS transistor **M8** is connected to the source of the p-MOS transistor **M7** for providing the output **Q** of the output inverter **40.** The gate of the transistor **M7** is connected to the gate of the transistor **M8** for receiving an input signal from node N05. The state of the output **Q** is complementary to the state of the signal at node **N05.**

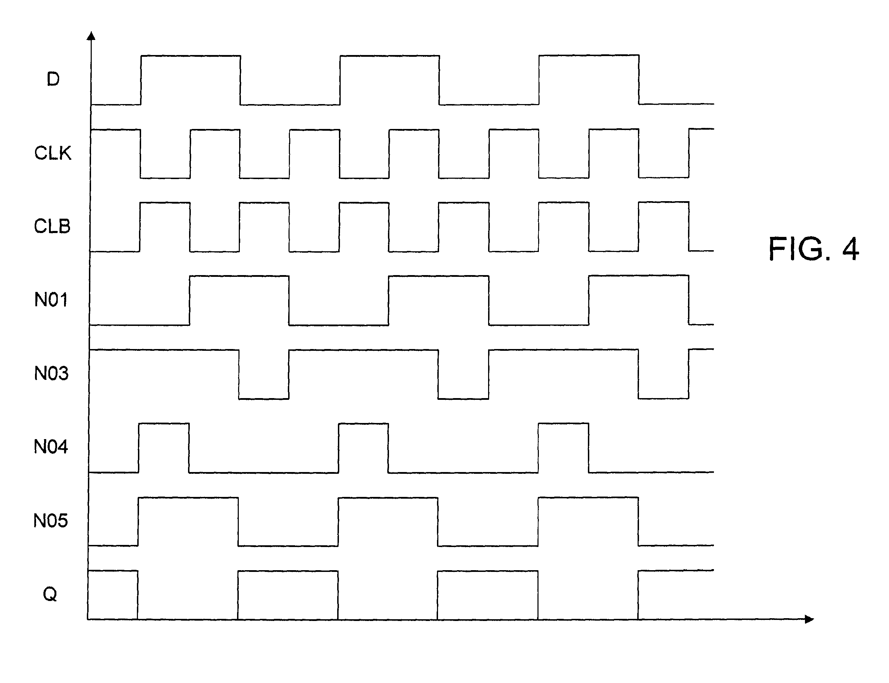

In order to show how the clocked D-type Flip-Flop circuit works, the signal levels at various nodes in the circuit are shown in the time chart of Figure 4. The node N03 is located between **M3** and M4 of the clock-controlled inverter **30** and the node N04 is located between **M5** and **M6.**

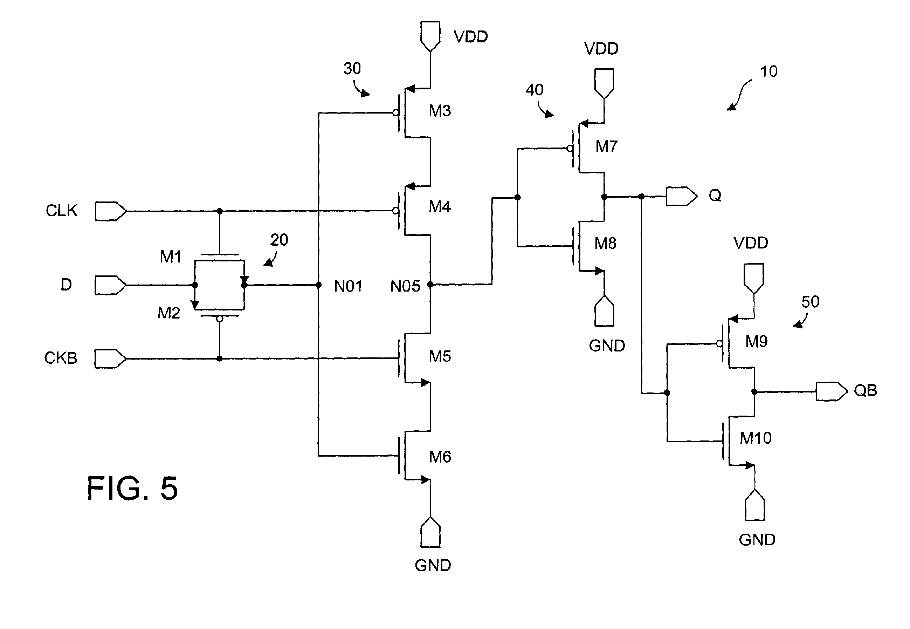

Figure 5 shows a clocked D-type Flip-Flop circuit, according to another embodiment of the present invention. In addition to the output **Q** provided from the output inverter **40,** a complementary output **QB** is provided from another output inverter **50.** As shown in Figure 5, the output **Q** of the output inverter **40** is provided to the output inverter **50.** The state of the output **QB** is complementary to the state of signal **Q.**

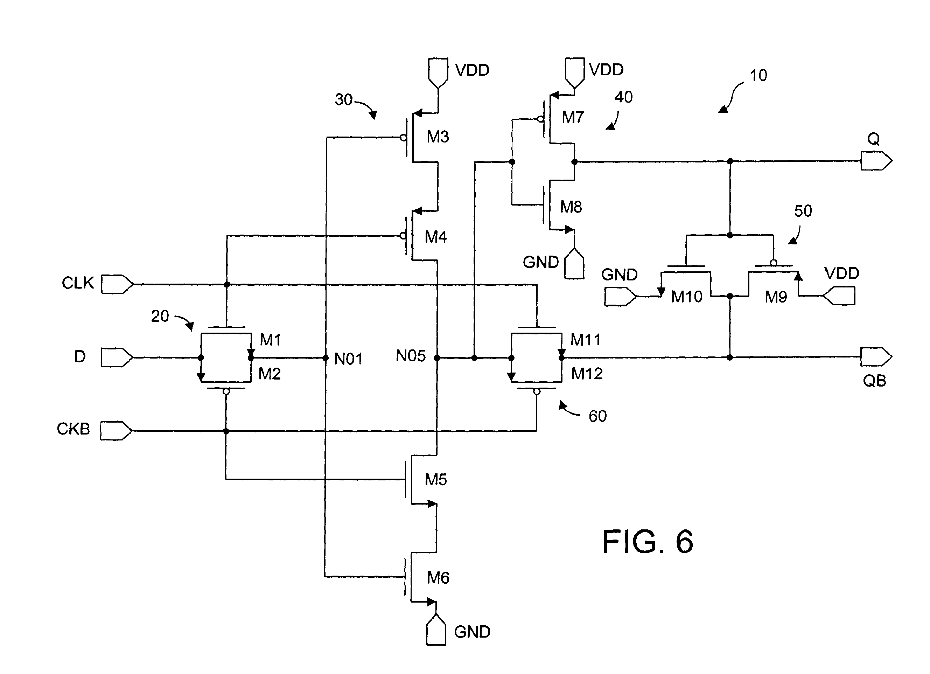

Figure 6 shows a clocked D-type Flip-Flop circuit, according to yet another embodiment of the present invention. The Flip-Flop circuit as shown in Figure 6 is similar to the circuit shown in Figure 5, except that another transmission gate **60** is provided between node **N05** and the output **QB** of the output inverter **50.** As shown in Figure 6, the transmission gate **60** comprises an n-MOS transistor **M11** and a p-MOS transistor **M12.** The source of the n-MOS transistor **M11** is connected to the drain of the p-MOS transistor **M12** for receiving an input signal from node **N05**. The drain of the n-MOS transistor **M11** is connected to the source of the p-MOS transistor **M12** for providing an output signal to the output terminal of the output inverter **50.** The gate of the n-MOS transistor **M11** is configured to receive a clock signal **CLK** and the gate of p-MOS transistor **M12** is configured to receive a complementary clock signal **CKB**. The adoption of n-MOS transistor **M11** and p-MOS transistor **M12** can avoid node **N05** from floating, and prevent the transistors **M7, M8, M9** and **M10** from working in an unstable state. That is, the use of transmission gate **60** can reduce the noise disturbance and increase the noise immunity.

In sum, the present invention provides a clocked D-type Flip-Flop circuit, which comprises: a transmission gate, a clock controlled inverter and an output converter. The transmission gate provides an intermediate signal, in response to an input data and complementary clock signals, to the clock controlled inverter which has four switches connected in series in a switching series.

In particular, the transmission gate comprises an input end for receiving an input signal (D) and an output end (N01) for providing a first output signal in response to the input signal, the transmission gate configured for receiving a first clock signal (CLK) and a second clock signal (CKB) complementary to the first clock signal for controlling the first output signal.

The switching series has a first series end and an opposing second series end, the first series end connected to a first voltage source (VDD) and the second series end connected to a second voltage level source (GND) different from the first voltage level source, the switching series comprising a plurality of switching elements (M3-M6) connected in series, wherein the plurality of switching elements comprise:
a first switching element (M3) at the first series end;
a second switching element (M4) electrically connected to the first switching element;
a third switching element (M5) electrically connected to the second switching element; and
a fourth switching element (M6) electrically connected between the third switching element and the second series end, wherein each of the first switching element, the second switching element, the third switching element and the fourth switching element is operable in two complementary switching states, and wherein
the first output signal is arranged to cause the first switching element and the fourth switching element to operate between said two switching states, such that the switching states of the first switching element are complementary to the switching states of the fourth switching element;
the first clock signal is arranged to cause the second switching element to operate between said two switching states; and the second clock signal is arranged to cause the third switching element to operate between said two switching states, such that the switching states of the second switching element are the same as the switching states of the third switching element, and wherein the switching series is configured to provide a second output signal at a first output point (N05) between the second switching and third switching element.

The Flip-Flop circuit also has a module electrically connected to the first output point for providing a third output signal (Q) in response to the second output signal. The module comprises a converter circuit such that the third output signal is complementary to the second output signal.

In one embodiment of the present invention, the first switching element comprises a p-type transistor having a gate terminal arranged for receiving the first output signal; the second switching element comprises a p-type transistor having a gate terminal arranged for receiving the first clock signal; the third switching element comprises an n-type transistor having a gate terminal arranged for receiving the second clock signal; and the fourth switching element comprises an n-type transistor having a gate terminal arranged for receiving the first output signal.

In one embodiment of the present invention, the transmission gate comprises: an n-type transistor (M1) having a first drain terminal electrically connected to the output end (N01) of the transmission gate, a first source terminal electrically connected to the input end of the transmission gate, and a first gate terminal arranged for receiving the first clock signal; and a p-type transistor (M2) having a second source terminal electrically connected to the first drain terminal, a second drain terminal electrically connected to the first source terminal, and a second gate terminal arranged for receiving the second clock signal.

In one embodiment of the present invention, the converter circuit comprises: a p-type transistor (M7) electrically connected to the first voltage level source (VDD); and an n-type transistor (M8) connected between the p-type transistor and the second voltage level input (GND), wherein each of the p-type transistor (M7) and the n-type transistor (M8) has a gate terminal arranged for receiving the second output signal, and wherein the converter circuit further comprises a second output point between the p-type transistor and the n-type transistor for providing the third output signal (Q).

In one embodiment of the present invention, the Flip-Flop circuit also includes a second converter circuit electrically connected to the second output point for providing a fourth output signal (QB) in response to the third output signal (Q) such that the fourth output signal is complementary to the third output signal. The second converter circuit comprises: a second p-type transistor (M9) electrically connected to the first voltage level input (VDD); and a second n-type transistor (M10) connected between the second p-type transistor and the second voltage level input (GND), wherein each of the second p-type transistor (M9) and the second n-type transistor (M10) has a second gate terminal arranged for receiving the second output signal, and wherein the second converter circuit further comprises a third output point between the second p-type transistor and the second n-type transistor for providing the fourth output signal (QB).

In one embodiment of the present invention, the Flip-Flop circuit further includes a second transmission gate (60), the second transmission gate arranged to receive the first clock signal (CLK) and the second clock signal (CKB), wherein the second transmission gate comprises a first gate end connected to the first output point (N05) for receiving the second output signal, and a second gate end connected to the third output point in the second converter circuit (50). The second transmission gate comprises: an n-type transistor (M11) having a drain terminal electrically connected to the third output point of the second converter circuit, a source terminal electrically connected to the first gate end, and a gate terminal arranged for receiving the first clock signal; and a p-type transistor (M12) having a source terminal electrically connected to the drain terminal of the n-type transistor in the second transmission gate, a drain terminal electrically connected to the source terminal of the n-type transistor in the second transmission gate, and a second gate terminal arranged for receiving the second clock signal.

Thus, although the present invention has been described with respect to one or more embodiments thereof, it will be understood by those skilled in the art that the foregoing and various other changes, omissions and deviations in the form and detail thereof may be made without departing from the scope of this invention.

## Claims

1. An electronic circuit, comprising:
a transmission gate comprising an input end for receiving an input signal and an output end for providing a first output signal in response to the input signal, the transmission gate configured for receiving a first clock signal and a second clock signal complementary to the first clock signal for controlling the first output signal;
a switching series having a first series end and an opposing second series end, the first series end connected to a first voltage source and the second series end connected to a second voltage level source different from the first voltage level source, the switching series comprising a plurality of switching elements connected in series, said plurality of switching elements comprising:
a first switching element at the first series end;
a second switching element electrically connected to the first switching element;
a third switching element electrically connected to the second switching element; and
a fourth switching element electrically connected between the third switching element and the second series end, wherein each of the first switching element, the second switching element, the third switching element and the fourth switching element is operable in two complementary switching states, and wherein
the first output signal is arranged to cause the first switching element and the fourth switching element to operate between said two switching states, such that the switching states of the first switching element are complementary to the switching states of the fourth switching element;
the first clock signal is arranged to cause the second switching element to operate between said two switching states; and the second clock signal is arranged to cause the third switching element to operate between said two switching states, such that the switching states of the second switching element are the same as the switching states of the third switching element, and wherein the switching series is configured to provide a second output signal at a first output point (N05) between the second switching and third switching element.

2. The electronic circuit of claim 1, further comprising:
a module electrically connected to the first output point for providing a third output signal in response to the second output signal.

3. The electronic circuit of claim 2, wherein the module comprises a converter circuit such that the third output signal is complementary to the second output signal.

4. The electronic circuit of claim 1, wherein
the first switching element comprises a p-type transistor having a gate terminal arranged for receiving the first output signal;
the second switching element comprises a p-type transistor having a gate terminal arranged for receiving the first clock signal;
the third switching element comprises an n-type transistor having a gate terminal arranged for receiving the second clock signal; and
the fourth switching element comprise an n-type transistor having a gate terminal arranged for receiving the first output signal.

5. The electronic circuit of claim 1, wherein the transmission gate comprising:
an n-type transistor having a first source terminal electrically connected to the output end of the transmission gate, a first drain terminal electrically connected to the input end of the transmission gate, and a first gate terminal arranged for receiving the first clock signal; and
a p-type transistor having a second source terminal electrically connected to the first drain terminal, a second drain terminal electrically connected to the first source terminal, and a second gate terminal arranged for receiving the second clock signal.

6. The electronic circuit of claim 3, wherein the converter circuit comprises:
a p-type transistor electrically connected to the first voltage level source; and
an n-type transistor connected between the p-type transistor and the second voltage level input, wherein each of the p-type transistor and the n-type transistor has a gate terminal arranged for receiving the second output signal, and wherein the converter circuit further comprises a second output point between the p-type transistor and the n-type transistor for providing the third output signal.

7. The electronic circuit of claim 6, further comprising:
a second converter circuit electrically connected to the second output point for providing a fourth output signal in response to the third output signal such that the fourth output signal is complementary to the third output signal.

8. The electronic circuit of claim 7, wherein the second converter circuit comprises:
a second p-type transistor electrically connected to the first voltage level input; and
a second n-type transistor connected between the second p-type transistor and the second voltage level input, wherein each of the second p-type transistor and the second n-type transistor has a second gate terminal arranged for receiving the second output signal, and wherein the second converter circuit further comprises a third output point between the second p-type transistor and the second n-type transistor for providing the fourth output signal.

9. The electronic circuit of claim 8, further comprising:
a second transmission gate arranged to receive the first clock signal and the second clock signal, wherein the second transmission gate comprises a first gate end connected to the first output point for receiving the second output signal, and a second gate end connected to the third output point in the second converter circuit.

10. The electronic circuit of claim 9, wherein the second transmission gate comprises:
an n-type transistor having a drain terminal electrically connected to the third output point of the second converter circuit, a source terminal electrically connected to the first gate end, and a gate terminal arranged for receiving the first clock signal; and
a p-type transistor having a source terminal electrically connected to the drain terminal of the n-type transistor in the second transmission gate, a drain terminal electrically connected to the source terminal of the n-type transistor in the second transmission gate, and a second gate terminal arranged for receiving the second clock signal.
